(19) Europäisches Patentamt
European Patent Office
Office européen des brevets

(11) EP 1 881 741 A1

# (12) EUROPEAN PATENT APPLICATION

published in accordance with Art. 153(4) EPC

(43) Date of publication:
**23.01.2008 Bulletin 2008/04**

(21) Application number: **06732325.3**

(22) Date of filing: **25.04.2006**

(51) Int Cl.:
***H05B 1/00*** *(2006.01)*

(86) International application number:
**PCT/JP2006/308665**

(87) International publication number:
**WO 2006/120895 (16.11.2006 Gazette 2006/46)**

(84) Designated Contracting States:
**DE FR GB**

(30) Priority: **12.05.2005 JP 2005139452**

(71) Applicant: **IDEMITSU KOSAN CO., LTD.**
**Tokyo 100-8321 (JP)**

(72) Inventors:
- **HACHIYA, Satoshi**
  **1280 Chiba (JP)**
- **KATANO, Junichi**
  **1280 Chiba (JP)**

(74) Representative: **Gille Hrabal Struck Neidlein Prop Roos**
**Patentanwälte**
**Brucknerstrasse 20**
**40593 Düsseldorf (DE)**

## (54) COLOR CONVERTING MATERIAL COMPOSITION AND COLOR CONVERTING MEDIUM INCLUDING SAME

(57) A color converting material composition including: a light-transmissible matrix; a fluorescent semiconductor nanocrystal which absorbs at least light in a first wavelength region; and an organic fluorescent dye which absorbs at least light in a second wavelength region.

FIG. 2

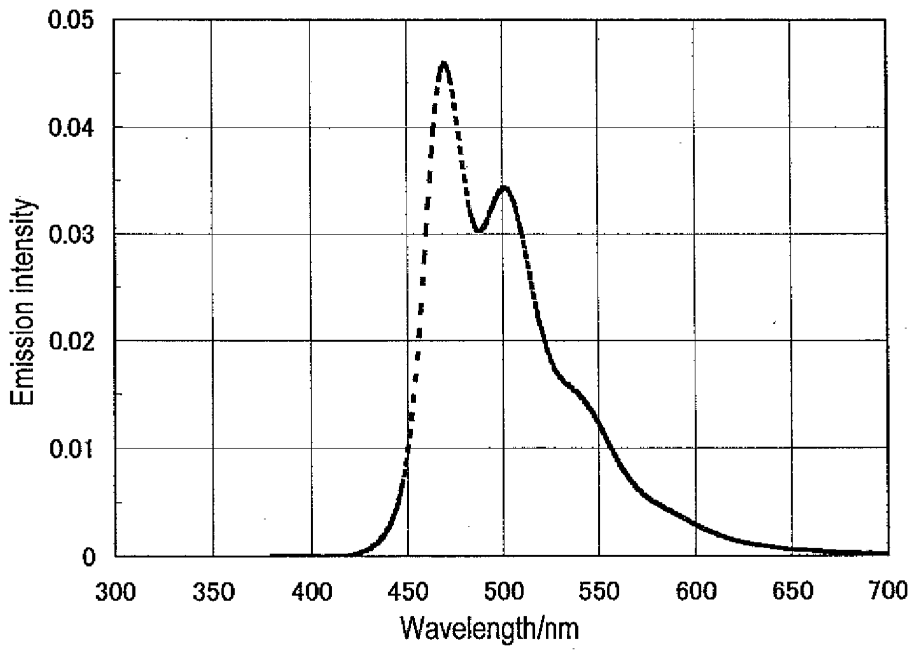


EP 1 881 741 A1

## Description

TECHNICAL FIELD

The invention relates to a color converting material composition and a color converting medium (color converting film, color converting multi-layer stack, color converting substrate, emitting device) containing the same.

BACKGROUND

A color converting substrate utilizing a color converting material composition which converts the wavelength of light emitted from a light source using a fluorescent material has been applied in various fields including the electronic display field. An emitting apparatus utilizing a color converting substrate can emit light of a plurality of colors from a monochromic light source (blue light, for example).

An organic fluorescent material and an inorganic fluorescent material have been used as the fluorescent material used for the color converting material composition.

A fluorescent dye and a fluorescent pigment have been studied as the organic fluorescent material. As the inorganic fluorescent material, a material of a metal oxide, sulfide, or the like doped with a transition metal ion, a material of a metal chalcogenide doped with a transition metal ion, and a fluorescent semiconductor nanocrystal utilizing the band gap of a semiconductor have been studied.

Among the above, the fluorescent semiconductor nanocrystal is formed by forming a semiconductor into ultrafine particle (diameter: 10 nm or less) to exhibit specific light absorption/emission characteristics due to electron confinement effects (quantum size effects). The fluorescent semiconductor nanocrystal has the following features since it is an inorganic material.

(a) Stable against heat and light (highly durable)
(b) Free from concentration quenching
(c) High fluorescence quantum yield (high device efficiency)
(d) No light scattering because of being ultrafine particles (high contrast)
(e) Adjustable to emit sharp fluorescence at an arbitrary wavelength by changing the particle size (wide color variety and high efficiency).

As an example of a color converting substrate using semiconductor nanocrystal, Patent Document 1 discloses color converting substrates in which semiconductor nanocrystal is used for a green fluorescent layer and a red fluorescent layer. The semiconductor nanocrystal has a high fluorescence quantum yield, and therefore, can convert colors if an appropriate light source is selected.

However, when an organic electroluminescent device (hereinafter "electroluminescent" will be abbreviated as "EL") or the like is used as a light source, a color converting substrate using a semiconductor nanocrystal suffers deteriorated purity of converted light. The reason therefor will be explained below.

FIG. 1 shows one example of the absorption spectrum of a fluorescent semiconductor nanocrystal. As is apparent from FIG. 1, the fluorescent semiconductor nanocrystal absorbs light mainly in the UV-blue region. On the other hand, if a common organic EL element is used, the emission therefrom has a broad emission spectrum in the visible region, as shown in FIG. 2. Therefore, when an organic EL element is combined with a color converting substrate containing a fluorescent semiconductor nanocrystal, the fluorescent semiconductor nanocrystal cannot sufficiently absorb emission from the organic EL element. As a result, the amount of leaked light which passes through the color converting substrate without being converted increases, causing the purity of displayed light to deteriorate.

FIG. 3 shows one example of an emission spectrum of an emission device obtained by combining an organic EL element and a color converting substrate using the fluorescent semiconductor nanocrystal. In this emission device, as the organic EL element, an organic EL element which has an emission spectrum shown in FIG. 2 is used, and as the fluorescent semiconductor nanocrystal, a fluorescent semiconductor nanocrystal which emits fluorescence in the red region is used.

From FIG. 3, it is understood that light with a wavelength of around 500 nm emitted from the organic EL element is mixed with displayed light as it is, without being converted at the color converting substrate.

Use of a color filter in combination is a known technique to improve color purity. However, if the amount of unnecessary light components is extremely large, as shown in FIG. 3, color purity cannot be corrected to a sufficient level.

Patent Document 1: USP No. 6,608,439

The invention has been made in view of the above problems, and an object thereof is to provide a color converting material composition and a color converting film used in a color converting substrate which exhibits a high degree of color purity.

SUMMARY OF THE INVENTION

The inventors made extensive studies to solve the above problems. As a result, the inventors have found that color purity and color conversion efficiency can be improved by using a fluorescent semiconductor nanocrystal and an organic fluorescent dye in combination to convert, of light emitted from a light source, light components in a shorter wavelength region (first wavelength region) mainly by the fluorescent semiconductor nanocrystal and convert light components in a wavelength region longer than the above region (second wavelength region) by the organic fluorescent dye. The invention has been made based on this finding.

The invention provides the following color converting material composition, the color converting film, the color converting multi-layer stack, the color converting substrate, and the emitting device.

1. A color converting material composition comprising:

   a light-transmissible matrix;
   a fluorescent semiconductor nanocrystal which absorbs at least light in a first wavelength region; and
   an organic fluorescent dye which absorbs at least light in a second wavelength region.

2. The color converting material composition according to 1, wherein the first wavelength region is 350 to 500 nm and the second wavelength region is 500 to 590 nm.
3. The color converting material composition according to 1 or 2 which converts the absorbed light to light in a wavelength region of 600 to 630 nm and radiates the converted light.
4. The color converting material composition according to 1, wherein the first wavelength region is 350 to 470 nm and the second wavelength region is 470 to 520 nm.
5. The color converting material composition according to 1 or 4 which converts the absorbed light to light in a wavelength region of 520 to 540 nm and radiates the converted light.
6. The color converting material composition according to any one of 1 to 5, wherein the organic fluorescent dye is a compound having a perylene skeleton.
7. A color converting film comprising the color converting material composition according to any one of 1 to 6.
8. A color converting substrate comprising:

   a substrate; and
   the color converting film according to 7 formed on the substrate.

9. A color converting multi-layer stack comprising:

   a first color converting film which contains a first light-transmissible matrix and a fluorescent semiconductor nanocrystal which absorbs light in a first wavelength region; and
   a second color converting film which contains a second light-transmissible matrix and an organic fluorescent dye which absorbs light in a second wavelength region.

10. A color converting substrate comprising:

   a substrate; and
   the color converting multi-layer stack according to 9 formed on the substrate.

11. An emitting device comprising:

   a light source having a primary emission wavelength region of 350 to 590 nm; and
   the color converting film according to 7, the color converting substrate according to 8 or 10, or the color converting multi-layer stack according to 9.

12. The emitting device according to 11, wherein the light source is an organic electroluminescent element.

In the color converting material composition and the color converting substrate or the like using the same according to the invention, color purity and color conversion efficiency can be improved.

## BRIEF DESCRIPTION OF THE DRAWINGS

FIG. 1 is one example of an absorption spectrum of a fluorescent semiconductor nanocrystal;
FIG. 2 is one example of an emission spectrum of an organic EL element;
FIG. 3 is one example of an emission spectrum of an emitting device obtained by combining an organic EL element and a color converting substrate using a fluorescent semiconductor nanocrystal; and
FIG. 4 is a schematic cross-sectional view of an evaluation sample.

## BEST MODE FOR CARRYING OUT THE INVENTION

The invention will be described in detail as follows. A. Color converting material composition
The color converting material composition of the invention comprises a light-transmissible matrix, a fluorescent semiconductor nanocrystal which absorbs light in a first wavelength region, and an organic fluorescent dye which absorbs light in a second wavelength region.
Preferably, the color converting material composition of the invention comprises a light-transmissible matrix, a fluorescent semiconductor nanocrystal which absorbs light in a first wavelength region and emits light in a third wavelength region, and an organic fluorescent dye which absorbs light in a second wavelength region and emits light in a third wavelength region. Here, the third wavelength region, the second wavelength region, and the first wavelength region indicate long wavelength regions in this order.
By the combined use of a fluorescent semiconductor nanocrystal and an organic fluorescent dye, of light emitted from a light source, light components in the shorter wavelength region (first wavelength region) can be converted by the fluorescent semiconductor nanocrystal, and light components in a wavelength region longer than the above region (second wavelength region) can be converted by the organic fluorescent dye.
For example, in the case of the color converting material composition which converts light emitted from a light source to red light, light in the UV-blue region (350 to 500 nm) can be converted to red light (600 to 630 nm) by the fluorescent semiconductor nanocrystal, and light in the blue-orange region (500 to 590 nm) can be converted to red light by the organic fluorescent dye. As a result, light which is mixed in displayed light as leaked light can be converted to red light and used effectively, resulting in improvement in color conversion efficiency and color purity.
In the case of the color converting material composition which converts light emitted from a light source to green light, light in the UV-blue region (350 to 470 nm) can be converted to green light (520 to 540 nm) by the fluorescent semiconductor nanocrystal, and light in the blue-bluish green region (470 to 520 nm) can be converted to green light by the organic fluorescent dye.
In the invention, as mentioned above, it is preferred that the first wavelength region be 350 to 500 nm, the second wavelength region be 500 to 590 nm, and the third wavelength region be 600 to 630 nm. In other words, it is preferred the color converting material composition be a red converting material composition.
Since the interval between the light-absorption region and the fluorescence wavelength peak is large, the fluorescent semiconductor nanocrystal does not sufficiently absorb light in the blue-yellow region. Therefore, as shown in FIG. 3, the amount of leaked light is large in a region of 500 to 590 nm when the fluorescent semiconductor nanocrystal is used alone.
On the other hand, since the excitation wavelength peak and the fluorescence wavelength peak appear more closely as compared with the case of the fluorescent semiconductor nanocrystal, the organic fluorescent dye can convert light in the blue-yellow region to red light.
Therefore, by the combined use of the fluorescent semiconductor nanocrystal and the organic fluorescent dye, a red color converting material composition improved in color conversion efficiency and color purity can be obtained.
The fluorescent semiconductor nanocrytal is required to absorb only part of light in the first wavelength region, and is not required to absorb all of the light in this wavelength region. The fluorescent semiconductor nanocrystal may absorb light outside this wavelengh region. Similarly, the organic fluorescent dye is required to absorb only part of light in the second wavelength region, and is not required to absorb all of the light in this wavelength region. Further, the organic fluorescent dye may absorb light outside this wavelength region. For effective absorption of light in a wavelength region which cannot be absorbed by the fluorescent semiconductor nanocrystal, it is preferred that the organic fluorescent dye have an absorption peak wavelength in the second wavelength region.
In addition, it is preferred that fluorescence emitted from the fluorescent semiconductor nanocrystal and the organic fluorescent dye have the maximum peak wavelength in the third wavelength region.
The members constituting the color converting material composition of the invention will be explained below.

1. Light-transmissible matrix

The light-transmissible matrix is a medium for dispersing and holding the fluorescent material. Transparent materials such as glass and transparent resins can be selected as the light-transmissible matrix.
Specific examples include transparent resins (polymers) such as polymethyl methacrylate, polyacrylate, polycarbonate, polyvinyl alcohol, polyvinylpyrrolidone, hydroxyethyl cellulose, and carboxymethyl cellulose.
A photosensitive resin for photolithography may also be used in order to separately arrange a fluorescent layer in a plane.
Examples are photo-setting resist materials having reactive vinyl groups such as acrylic acid type, methacrylic acid type, polyvinyl cinnamate type and cyclic rubber type. In the case where a printing method is used, a printing ink (medium) using a transparent resin may be selected. Monomers, oligomers and polymers of polyvinyl chloride resins, melamine resins, phenol resins, alkyd resins, epoxy resins, polyurethane resins, polyester resins, maleic acid resins and polyamide resins can be exemplified.
They may be thermosetting resins.
These resins may be used singly or in mixtures.

2. Fluorescent semiconductor nanocrystal

As materials of the semiconductor nanocrystal, crystals formed of group (group of the long format of the periodic table) IV element compounds, group IIa element-group VIb element compounds, group IIIa element-group Vb element compounds, and group IIIb element-group Vb element compounds can be given.
Specific examples thereof include crystals of Si, Ge, MgS, ZnS, MgSe, ZnSe, AlP, GaP, AlAs, GaAs, CdS, CdSe, InP, InAs, GaSb, AlSb, ZnTe, CdTe, InSb and mixed crystals of these elements or compounds.
Of these, A1P, GaP, Si, ZnSe, AlAs, GaAs, CdS, InP, ZnTe, AlSb, CdTe, and CdSe are preferable. Of these, ZnSe, CdSe, GaAs, CdS, InP, ZnTe and CdTe, which are direct transition semiconductors, are particularly preferable from the viewpoint of high luminous efficiency.
In order to obtain desired fluorescence, the type and diameter of semiconductor nanocrystal are adjusted. When producing fluorescent semiconductor nanocrystals, the adjustment can be easily carried out by measuring absorption and fluorescence.
The fluorescent semiconductor nanocrystal can be produced using methods disclosed in USP No. 6,501,091, JP-A-2003-286292, JP-T-2004-510678, JP-A-2004-315661 and the like.
As a production example, a precursor solution prepared by mixing trioctyl phosphine (TOP) with trioctyl phosphine selenide and dimethylcadmium is added to trioctyl phosphine oxide (TOPO) heated at 350°C.
As another example of the fluorescent semiconductor nanocrystal used in the invention, core/shell semiconductor nanocrystal can be given. For example, the core/shell semiconductor nanocrystal has a structure in which the surface of a core fine particle formed of CdSe (band gap: 1.74 eV) is coated with a shell formed of a semiconductor material having a large band gap such as ZnS (band gap: 3.8 eV). This makes it easy to exhibit confinement effects on electrons produced in the core fine particle.
The core/shell semiconductor nanocrystals may be produced using the above known methods.
For example, a CdSe core/ZnS shell structure can be produced by adding a precursor solution prepared by mixing TOP with diethyl zinc and trimethylsilyl sulfide to a TOPO solution heated at 140°C in which CdSe core particles are dispersed.
In the above specific examples of the fluorescent semiconductor nanocrystal, a phenomenon tends to occur in which S, Se, or the like is removed by an active component (e.g. unreacted monomer or water) in the transparent medium (described later) to damage the crystal structure of the nanocrystal, whereby the fluorescent properties disappear.
In order to prevent this phenomenon, the surface of the semiconductor nanocrystal may be modified with a metal oxide such as silica, an organic substance, or the like.
In order to improve dispersibility in the transparent medium, the surface of the fine particles may be modified or coated with a long-chain alkyl group, phosphoric acid, a resin, or the like.
The above fluorescent semiconductor nanocrystal may be used either singly or in combination of two or more.

3. Organic fluorescent dye

As examples of the organic fluorescent dye, coumarin dyes such as 7-hydroxy-4-methylcoumarine (hereinafter referred to as "coumarin 4"), 2,3,5,6-1H,4H-tetrahydro-8-trifluoromethylquinolizino(9,9a,1-gh)coumarin (hereinafter referred to as "coumarin 153"), 3-(2'-benzothiazolyl)-7-diethylaminocoumarin (hereinafter referred to as "coumarin 6), 3-(2'-benzoimidazolyl)-7-diethylaminocoumarin (hereinafter referred to as "coumarin 7"); uranine, fluorescein dyes such as 9-(o-carboxyphenyl)-2,7-dichloro-6-hydroxy-3H-xanten-3-one; naphthalimido dye such as solvent yellow 11 and solvent yellow 116; perylene dyes; and stilbene dyes.

Also, cyanine dyes such as 4-dicyanomethylene-2-methyl-6-(p-dimethylaminostyryl)-4H-pyran (hereinafter referred to as "DCM"); pyridine dyes such as 1-ethyl-2-(4-(p-dimethylaminophenyl)-1,3-butadienyl)-pyridinium-perchlorate (hereinafter referred to as "pyridine 1"); and rhodamine dyes such as rhodamine B and rhodamine 6G can be used. Various dyes (direct dyes, acidic dyes, basic dyes, disperse dyes and so on) can be selected if they have fluorescent properties.

The fluorescent dye that has been kneaded in advance into a pigment resin may be used. Such pigment resins include polymethacrylic acid esters, polyvinyl chlorides, vinyl chloride vinyl acetate copolymers, alkyd resins, aromatic sulfonamide resins, urea resins, melamine resins and benzoguanamine resins.
These fluorescent dyes or pigments may be used singly or in mixtures if necessary.

In the invention, it is preferable that the organic fluorescent dye have the perylene skeleton. The perylene dye exhibits excellent fluorescent properties and light durability and does not contain a highly reactive unsaturated bond in its molecule. Therefore, since the perylene dye is only slightly affected by the environment such as a matrix, nonuniform deterioration (image burn) of the emitting apparatus using the color converting substrate can be suppressed. As a result, a fluorescent layer exhibiting high conversion efficiency and excellent durability can be obtained.
As specific examples of the perylene dye, compounds shown by the following formulas (1) to (3) can be given.

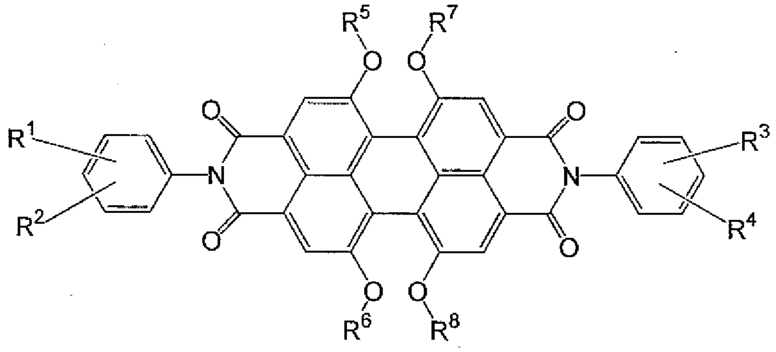

(1)

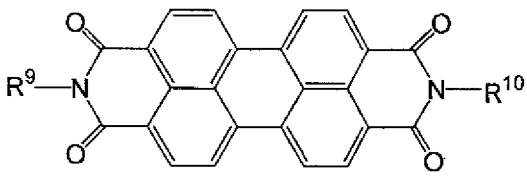

(2)

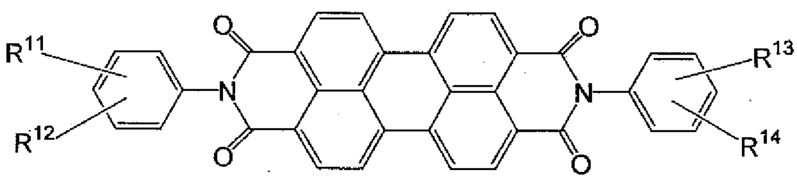

(3)

wherein $R^1$ to $R^4$ are independently hydrogen, a linear alkyl group, a branched alkyl group, or a cycloalkyl group, which may be substituted; $R^5$ to $R^8$ are independently a phenyl group, a heteroaromatic group, a linear alkyl group, or a branched alkyl group, which may be substituted; $R^9$ and $R^{10}$ are independently hydrogen, a linear alkyl group, a branched alkyl group, or a cycloalkyl group, which may be substituted; and $R^{11}$ to $R^{14}$ are independently hydrogen, a linear alkyl

group, a branched alkyl group, or a cycloalkyl group, which may be substituted.

It is preferred that the light-transmissible matrix in the total color converting material composition of the invention be 20 wt% to 99 wt%, with 40 wt% to 99 wt% being particularly preferable.

It is preferred that the fluorescent semiconductor nanocrystal in the total color converting material composition of the invention be 0.1 wt% to 60 wt%, with 0.1 wt% to 40 wt% being particularly preferable.

It is preferred that the organic florescent dye in the total color converting material composition of the invention be 0.1 wt% to 10 wt%, with 0.1 wt% to 2 wt% being particularly preferable.

In addition to the components as mentioned above, the color converting material composition of the invention may contain such additives as a photopolymerization initiator, a sensitizer, a cure promoter, a thermopolymerization inhibitor, a plasticizer, a filler, a solvent, a defoaming agent, and a leveling agent as required.

B. Color converting film and color converting multi-layer stack

The color converting film of the invention is obtained by forming the above-mentioned color converting material composition into a film by a known method.

The color converting multi-layer stack of the invention is obtained by stacking a first color converting film comprising a first light-transmissible matrix and a fluorescent semiconductor nanocrystal which absorbs light in the first wavelength region and a second color converting film comprising a second light-transmissible matrix and the organic fluorescent material which absorbs light in the second wavelength region.

Since both the color converting film and the color converting multi-layer stack of the invention contain both the fluorescent semiconductor nanocrystal and the organic fluorescent dye, the above-mentioned advantageous effects of the invention can be obtained.

The mixing ratio of the fluorescent semiconductor nanocrystal to the light-transmissible matrix (fluorescent semiconductor nanocrystal/light-transmissible matrix: weight ratio) in the first color converting film is preferably 1/20 to 4/6, and still more preferably 1/9 to 3/7, although the mixing ratio varies depending on the specific gravity and the particle size of the fluorescent semiconductor nanocrystal. If the mixing ratio is less than 1/20, the fluorescent semiconductor nanocrystal may not sufficiently absorb the light emitted from the emitting device, whereby conversion capability may be lowered or chromaticity after conversion may deteriorate. If the thickness of the converting layer is increased in order to allow the converting layer to absorb the light emitted from the emitting device, the mechanical stability of the emitting apparatus may be decreased due to thermal stress or the like, or it may become difficult to make the color conversion substrate flat. This may result in improper distances between the emitting devices and the color conversion substrate, whereby the visibility (e.g. viewing angle characteristics) of the emitting apparatus may be adversely affected.

If the mixing ratio exceeds 4/6, it may become difficult to stably disperse the fluorescent semiconductor nanocrystal by controlling the particle size. Further the light outcoupling efficiency may be decreased due to an increase in the refractive index, or it may become difficult to form a pattern.

The mixing ratio of the organic fluorescent dye and the light-transmissible matrix (organic fluorescent dye/light-transmissible matrix : weight ratio) in the second color converting film is preferably 1/10000 to 1/20, more preferably 1/1000 to 1/30, although the mixing ratio depends on the kind of the organic fluorescent dye. If the mixing ratio is smaller than 1/10000, conversion capability may be lowered or chromaticity after conversion may deteriorate. If the mixing ratio exceeds 1/20, the organic fluorescent dyes may contact with other to cause concentration quenching.

The thickness of the color converting film of the invention is preferably 1 μm to 100 μm, particularly preferably 1 μm to 30 μm.

The thickness of the first color converting film of the color converting multi-layer stack is preferably 1 μm to 100 μm, particularly preferably 1 μm to 30 μm.

The thickness of the second color converting film of the invention is preferably 1 μm to 20 μm, particularly preferably 1 μm to 15 μm.

In the color converting multi-layer stack, it is preferred that the first color converting film containing the fluorescent semiconductor nanocrystal be formed near the light source. By this configuration, deterioration of the organic fluorescent dye can be suppressed.

The first and second light-transmissible matrices may be formed of the same material or different materials.

The color converting film and the color converting multi-layer stack can be prepared, for example, by adding a suitable solvent to a fluorescent semiconductor nanocrystal and/or an organic fluorescent dye and a light-transmissible matrix, mixing and dispersing by a known method such as milling or ultrasonic dispersion to obtain a dispersion, applying the resulting dispersion to a substrate, following by drying.

As the method for applying a solution of the color converting composition to a substrate, known methods such as the solution immersion method, the spraying method, and methods using a roll coater, a land coater or a spinner can be used. A pattern of a color converting film may be formed from this dispersion by photolithography or other various printing method.

C. Color converting substrate

The color converting substrate of the invention is obtained by forming the above-mentioned color converting film or the color converting multi-layer stack on a light-transmissible substrate.
As the substrate, a flat and smooth substrate having a transmittance of 50% or more to light within visible ranges of 400 to 700 nm. Specific examples thereof include glass plates and polymer plates.
Examples of the glass plate include soda-lime glass, barium/strontium-containing glass, lead glass, aluminosilicate glass, borosilicate glass, barium borosilicate glass, and quartz.
Examples of the polymer plate include polycarbonate, acrylic polymer, polyethylene terephthalate, polyethersulfide, and polysulfone.

D. Emitting device

The emitting device of the invention is obtained by combining a light source having a primary emission wavelength region of 350 to 590 nm with the above-mentioned color converting film, the color converting multi-layer stack, or the color converting substrate of the invention.
Here, the expression "having a primary emission wavelength region of 350 to 590 nm" means that the radiation energy of light in a wavelength region of 350 to 590 nm is 60% or more of the radiation energy of light emitted from the light source.
As the light source, organic EL elements, inorganic EL elements, semiconductor light-emitting diodes, fluorescent display tubes, or the like can be used. Of them, organic EL elements are preferable for the fabrication of a highly efficient emitting apparatus since a high luminance can be obtained at a low voltage.

EXAMPLES

The invention will be described in more detail according to the examples.

[Preparation of fluorescent semiconductor nanocrystal]

Synthesis Example 1

(1) 0.5 g of cadmium acetate dihydrate and 1.6 g of tetradecylphosphonic acid (TDPA) were added to 5 ml of trioctylphosphine (TOP). The resulting solution was heated to 230°C and stirred for one hour in a nitrogen atmosphere. After cooling the solution to 60°C, 2 ml of a TOP solution containing 0.2 g of selenium was added to the solution to obtain a raw material solution.
10 g of trioctylphosphine oxide (TOPO) was placed in a three-necked flask and dried at 195°C for one hour under vacuum. After setting the pressure inside the flask at atmospheric pressure using nitrogen gas, the TOPO was heated to 270°C in a nitrogen atmosphere. 1.5 ml of the above raw material solution was added to the TOPO while stirring the system to allow a reaction to initiate.
The reaction was continued while confirming the growth of the nanocrystal. When the particle size of the nanocrystal became a desired size, the reaction solution was cooled to 60°C to terminate the reaction.
20 ml of butanol was added to the reaction solution to allow the nanocrystal to precipitate. The nanocrystal was separated by centrifugation and dried under reduced pressure, whereby a semiconductor nanocrystal (core) was obtained.

(2) TOPO (5 g) was placed in a three-necked flask and dried at 195°C for one hour under vacuum. After setting the pressure inside the flask at atmospheric pressure using nitrogen gas, the TOPO was cooled to 60°C in a nitrogen atmosphere. Then, TOP (0.5 ml) and the above-obtained semiconductor nanocrystal (core) (0.05 g) suspended in 0.5 ml of hexane were added to the TOPO. After stirring the mixture at 100°C for one hour under reduced pressure, the mixture was heated to 160°C. The pressure inside the flask was then set at atmospheric pressure using nitrogen gas to obtain solution A.

Solution B of room temperature which had been separately prepared (a solution prepared by dissolving 0.7 ml of a 1 N n-hexane solution of diethyl zinc and 0.13 g of bis(trimethylsilyl)sulfide in 3 ml of TOP)) was added dropwise to the solution A maintained at 160°C over a period of 30 minutes. The mixture was then cooled to 90°C, stirred for two

hours, and further cooled to 60°C.
20 ml of butanol was added to the mixture to allow a semiconductor nanocrystal (core/shell) to precipitate. The semiconductor nanocrystal was separated by centrifugation, dried under reduced pressure, and dispersed in toluene.
The dispersion was stored as the fluorescent semiconductor nanocrystal solution. The solution was excited with light of 450 nm from the light source. It was found that the resulting fluorescent semiconductor nanocrystal had a fluorescent peak at 615 nm.

Synthesis Example 2

(Synthesis of ZnTe/ZnSe semiconductor nanocrystal)

The ZnTe/ZnSe semiconductor nanocrystal was synthesized with reference to JP-T-2003-505330. Specifically, TOPO (40 g) and myristic acid (0.1 g) were placed in a four-necked flask and dried at 180°C for two hours under reduced pressure. After setting the pressure inside the flask at atmospheric pressure using nitrogen gas, a zinc acetate/TOP solution which had been prepared separately (8.5 ml, containing 0.3 g of zinc acetate) and heated to 100°C was added. The resulting mixture was heated to 330°C.
A tellurium/hexapropylphosphorous triamide/TOP solution (1.5 ml, containing 0.3 g of tellurium) was poured into the above four-necked flask, and the resulting mixture was stirred at 280°C for 2 hours.
The reaction solution was cooled to 150°C. A diethyl zinc/bis(trimethylsilyl)selenide/TOP solution (10 ml, containing 0.14 g of diethyl zinc, 0.25 g of bis(trimethylsilyl)selenide)) was added dropwise over a period of one hour. After completion of the dropwise addition, stirring was continued for further one hour at 150°C.
The reaction solution was cooled to 60°C, and cooled to room temperature after the addition of 30 ml of butanol. According to a known method, acetonitrile was added to allow a semiconductor nanocrystal to precipitate, whereby a ZnTe/ZnSe semiconductor nanocrystal was isolated. The isolated nanocrystal was dispersed in toluene, and stored.
The solution was excited with light of 450 nm from the light source. It was found that the resulting semiconductor nanocrystal emitted fluorescence having a peak at 527 nm.

Synthesis Example 3

(Synthesis of InP/ZnSe semiconductor nanocrystal)

TOPO (4 g) and TOP (36 g) was placed in a four-necked flask and dried at 100°C for two hours under reduced pressure. After setting the pressure inside the flask at atmospheric pressure using nitrogen gas, an indium acetate/TOPO/TOP solution which had been prepared separately (6.4 ml, containing 0.34 g of indium acetate, the TOPO/TOP amount ratio was the same as in the flask) and heated to 100°C was added. The resulting mixture was heated to 310°C.
A hexapropylphosphorous triamide/TOP solution (4.4 ml, containing 0.32 g of hexaethylphosphorous triamide) was added to the above four-necked flask, and the resulting mixture was stirred at 310°C for 2 hours.
The reaction solution was cooled to 150°C. A diethyl zinc/bis(trimethylsilyl)selenide/TOP solution (10 ml, containing 0.14 g of diethyl zinc, 0.25 g of bis(trimethylsilyl)selenide)) was added dropwise over a period of one hour. After completion of the dropwise addition, stirring was continued for further one hour at 150°C.
The reaction solution was cooled to 60°C, and cooled to room temperature after the addition of 30 ml of butanol. According to a known method, methanol was added to allow a semiconductor nanocrystal to precipitate, whereby the InP/ZnSe semiconductor nanocrystal was isolated. The isolated nanocrystal was dispersed in toluene, and stored.
The resulting nanocrystal was excited with light of 450 nm from the light source. It was found that the resulting semiconductor nanocrystal emitted fluorescence having a peak at 550 nm.

Example 1

0.1 g of amino-terminated polyethylene glycol (molecular weight: 3400, manufactured by Shearwater Polymers, Inc.) was added to the toluene dispersion of the fluorescent semiconductor nanocrystal synthesized in the Synthesis Example (containing 0.3 g of the fluorescent semiconductor nanocrystal), and stirred at 50°C for one hour. The toluene was then removed under reduced pressure.
The recovered residue (fluorescent semiconductor nanocrystal), 0.011 g of the organic dye shown by the following formula (4), 0.011 g of the organic dye shown by the following formula (5), 1.9 g of a methylmethacrylate/methacrylic acid copolymer (molecular weight: 20,000), 1.4 g of pentaerythritol triacrylate (Aronix M-305, manufactured by TOA GOSEI Co., Ltd.), 0.016 g of a photopolymerization initiator (Irugacure 907, manufactured by Ciba Speciality Chemicals, Inc.), 3.0 g of 2-acetoxy-1-methoxypropane (solvent), and 2.0 g of cyclohexanone (solvent) were weighed and mixed.
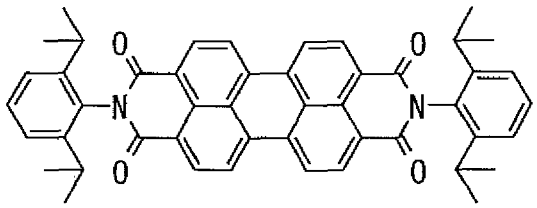

(4)

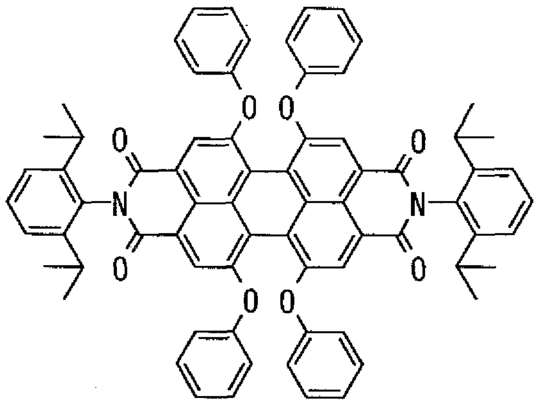

(5)

The organic fluorescent dye shown by the formula (4) absorbs light in a wavelength of 440 nm to 540 nm, and emits fluorescence having a peak at 553 nm and 586 nm.
The organic fluorescent dye shown by the formula (5) absorbs light in a wavelength of 490 nm to 590 nm, and emits fluorescence having a peak at 610 nm.

Using this solution, an evaluation sample (emitting device) shown in FIG. 4 was prepared.
1 ml of the solution was applied to a 50 mm x 50 mm glass substrate 1 by means of a spin coater. The spin coating was conducted at a revolution of 1000 rpm for 10 seconds. The solvent on this substrate was dried using a hot plate of 120°C. Subsequently, the substrate was irradiated with UV light of 365 nm (intensity: 300 mJ/$cm^2$) to cause a red converting film 3 to cure.
The red converting film 3 was post-cured in an oven at 200°C for one hour, whereby a color converting substrate having a 15 μm-thick red converting film 3 was prepared.

A blue-emitting organic EL element 2 having a peak wavelength at 470 nm, which had been prepared separately, was stacked on the color converting surface of the color converting substrate as obtained above, whereby an emitting device was fabricated.
The blue-emitting organic EL element 2 was allowed to emit light, and the color converting substrate was irradiated with the emitted blue light. The spectrum of the transmitted light through the color converting film 3 was measured by means of a chroma meter 5 (CS-1000, manufactured by Konica Minolta Holdings, Inc.) with a viewing angle of 2°, and chromaticity and color conversion efficiency were evaluated.
On the surface opposite to the surface on which the red converting film 3 of the red converting substrate was formed, a color filter 4 which cuts light with a wavelength of 550 nm or less was laminated.

The color converting efficiency was defined as follows.

(Color converting efficiency: %) = (Luminance of light which has transmitted the color filter) × 100/(Luminance of

the organic EL element)

Chromaticity and color converting efficiency after 1000 hour-continuous irradiation of the color converting substrate with blue light (intensity: 400 cd/$m^2$) in an atmosphere of nitrogen were measured, whereby durability of the color converting substrate was evaluated.
As for the color converting substrates obtained in Example 1 and Comparative Examples 1 and 2 given later, the results of the measurement of the initial values of color converting efficiency and chromaticity and those after the durability test are shown in Table 1.
Table 1

| | | Color converting efficiency | CIE chromaticity (x, y) |
|---|---|---|---|
| Example 1 | Initial value | 46% | 0.642, 0.357 |
| | After 1000 hours | 46% | 0.641, 0.358 |
| Comparative Example 1 | initial value | 41% | 0.634, 0.362 |
| | After 1000 hours | 41% | 0.637, 0.360 |
| Comparative Example 2 | Initial value | 19% | 0.628, 0.364 |
| | After 1000 hours | 18% | 0.619, 0.367 |

Comparative Example 1

A color converting substrate was prepared and evaluated in substantially the same manner as in Example 1, except that the organic fluorescent dyes shown by the formulas (4) and (5) were not added.

Comparative Example 2

A color converting substrate was prepared and evaluated in substantially the same manner as in Example 1, except that the fluorescent semiconductor nanocrystal was not added, and coumarin 6 (0.023 g), rhodamine 6G (0.023 g), and rhodamine B (0.023 g) were used instead of the organic fluorescent dyes shown by the formulas (4) and (5).
From the results shown in Table 1, it was confirmed that the color converting film of the invention had high conversion efficiency and excellent color purity.

Example 2

(1) Preparation of organic fluorescent dye solution

0.011 g of the organic fluorescent dye shown by the formula (4), 0.011 g of the organic fluorescent dye shown by the formula (5), 1.9 g of a methylmethacrylatemethacrylic acid copolymer (molecular weight: 20,000), 1.4 g of pentaerythritol triacrylate (M-305), 0.016 g of Irugacure 907 (photopolymerization initiator), 3.0 g of 2-acetoxy-1-methoxypropane (solvent), and 2.0 g of cyclohexanone (solvent) were weighed and mixed, whereby an organic fluorescent dye solution was obtained.

(2) Preparation of semiconductor nanocrystal solution

A semiconductor nanocrystal/amino-terminated polyethylene glycol adduct synthesized in the same manner as in Example 1, 1.9 g of a methylmethacrylate/methacrylic acid copolymer (molecular weight: 20,000), 1.4 g of pentaerythritol triacrylate (M-305), 0.016 g of Irugacure 907 (photopolymerization initiator), 3.0 g of 2-acetoxy-1-methoxypropane (solvent), and 2.0 g of cyclohexanone (solvent) were weighed and mixed, whereby a semiconductor nanocrystal solution was obtained.

(3) Preparation of color conversion multi-layer stack

1 ml of the organic fluorescent dye solution was applied to a 50 mm x 50 mm glass substrate by means of a spin coater (at a revolution of 1400 rpm for 10 seconds). The solvent on this substrate was dried using a hot plate of 120°C. The semiconductor nanocrystal solution was applied thereon by means of a spin coater (at a revolution of 1000 rpm for 10 seconds). Subsequently, the substrate was irradiated with UV light of 365 nm (intensity: 300 $mJ/cm^2$) to cause the coated film to cure.
The coated film was post-cured in an oven at 200°C for one hour, whereby a color converting multi-layer stack was prepared. In the multi-layer stack, the thickness of the layer containing the organic fluorescent dye was 6.5 μm and the thickness of the semiconductor nanocrystal layer was 10.7 μm.
The performance was evaluated in the same manner as in Example 1.
As for the color converting multi-layer stack obtained in Example 2, and those obtained in Examples 3, 4, and Comparative Example 3 given later, the results of the measurement of the initial values of color converting efficiency and chromaticity and those after the durability test are shown in Table 2.
Table 2

| | | Color conversion efficiency | CIE chromaticity (x, y) |
|---|---|---|---|
| Example 2 | Initial value | 48% | 0.644, 0.350 |
| | After 1000 hours | 48 % | 0.642, 0.354 |
| Example 3 | Initial value | 89% | 0.247, 0.673 |
| | After 1000 hours | 89% | 0.244, 0.671 |
| Example 4 | Initial value | 45% | 0.640, 0.355 |
| | After 1000 hours | 45% | 0.639, 0.357 |
| Comparative Example 3 | Initial value | 73% | 0.206, 0.657 |
| | After 1000 hours | 73% | 0.187, 0.618 |

Example 3

0.1 g of amino-terminated polyethylene glycol (molecular weight: 3400) was added to the toluene dispersion of the ZnTe/ZnSe semicondcutor nanocrystal synthesized in Synthesis Example 2 (containing 0.3 g of semiconductor nanocrystal), and stirred at 50°C for one hour. Thereafter, toluene was removed under reduced pressure.
The resulting residue, 0.020 g of the organic fluorescent dye shown by the following formula (6), 1.9 g of a methylmethacrylate/methacrylic acid copolymer (molecular weight: 20,000), 1.4 g of pentaerythritol triacrylate (M-305), 0.016 g of Irugacure 907 (photopolymerization initiator), 3.0 g of 2-acetoxy-1-methoxypropane (solvent), and 2.0 g of cyclohexanone (solvent) were weighed and mixed. The organic fluorescent dye shown by the formula (6) was synthesized with reference to JP-T-11-502545.
Using this solution, a color converting film was prepared and evaluated in substantially the same manner as in Example 1. In this example, instead of the red color filter, a color filter which cuts light with a wavelength of 500 nm or less and light with a wavelength of 580 nm or more was laminated.
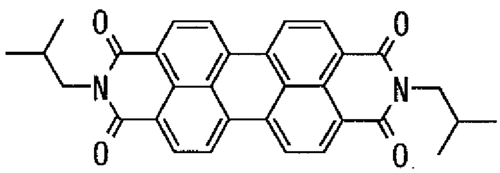
(6)

The organic fluorescent dye shown by the formula (6) absorbs light in a wavelength of 420 nm to 500 nm, and emits fluorescence having a peak at 525 nm.

Example 4

0.1 g of amino-terminated polyethylene glycol (molecular weight: 3400) was added to the toluene dispersion of the InP/ZnSe semicondcutor nanocrystal synthesized in Synthesis Example 3 (containing 0.3 g of semiconductor nanocrystal), and stirred at 50°C for one hour. Thereafter, toluene was removed under reduced pressure.
The resulting residues, 0.011 g of the organic dye shown by the formula (4), 0.011 g of the organic dye shown by the formula (5), 1.9 g of a methylmethacrylate/methacrylic acid copolymer (molecular weight: 20,000), 1.4 g of pentaerythritol triacrylate (M-305), 0.016 g of Irugacure 907 (photopolymerization initiator), 3.0 g of 2-acetoxy-1-methoxypropane (solvent), and 2.0 g of cyclohexanone (solvent) were weighed and mixed.
Using this solution, a color converting film was prepared and evaluated in substantially the same manner as in Example 1.

Comparative Example 3

0.034 g of coumarin 6, 1.9 g of a methylmethacrylatemethacrylic acid copolymer (molecular weight: 20,000), 1.4 g of pentaerythritol triacrylate (M-305), 0.016 g of Irugacure 907 (photopolymerization initiator), 3.0 g of 2-acetoxy-1-znethoxypropane (solvent), and 2.0 g of cyclohexanone (solvent) were weighed and mixed.
Using this solution, a color converting film was prepared and evaluated in substantially the same manner as in Example 4.
As a result, it was found that the color converting film obtained in Comparative Example 3 suffered a significant deterioration in chromaticity, though color conversion efficiency did not lower.

Example 5

An organic fluorescent dye solution was prepared in substantially the same manner as in Example 3, except that only the organic fluorescent dye shown by the formula (6) was added without adding the semiconductor nanocrystal. 1 ml of the organic fluorescent dye solution was applied to a 50 mm x 50 mm glass substrate by means of a spin coater (at a revolution of 2100 rpm for 10 seconds), and then dried using a hot plate of 120°C.
The same semiconductor nanocrystal solution as used in Example 4 was applied thereon by means of a spin coater (at a revolution of 1800 rpm for 10 seconds). Subsequently, the substrate was irradiated with UV light of 365 nm (intensity: 300 $mJ/cm^2$) to cause the coated film to cure.
The film was post-cured in an oven at 200°C for one hour, whereby a color converting multi-layer stack was prepared. In the multi-layer stack, the thickness of the layer containing the organic fluorescent dye was 2.0 μm and the thickness of the semiconductor nanocrystal layer was 3.5 μm.
This color converting multi-layer stack was irradiated with light emitted from the same blue-emitting organic EL element as used in other examples. As a result, white transmitted light with CIE chromaticity coordinates of (0.28, 0.30) was obtained. By adjusting the thickness or the like of the color converting film, the balance between absorption and transmission of light emitted from the light source and the converted light can be changed.
As a result, it is possible to obtain white light suitable for illuminators or the like.

INDUSTRIAL APPLICABILITY

The color converting material composition, the color converting film, and the color converting multi-layer stack of the invention can be suitably used for a variety of displays.

## Claims

**1.** A color converting material composition comprising:

a light-transmissible matrix;
a fluorescent semiconductor nanocrystal which absorbs at least light in a first wavelength region; and
an organic fluorescent dye which absorbs at least light in a second wavelength region.

**2.** The color converting material composition according to claim 1, wherein the first wavelength region is 350 to 500 nm and the second wavelength region is 500 to 590 nm.

**3.** The color converting material composition according to claim 1 or 2 which converts the absorbed light to light in a wavelength region of 600 to 630 nm and radiates the converted light.

**4.** The color converting material composition according to claim 1, wherein the first wavelength region is 350 to 470 nm and the second wavelength region is 470 to 520 nm.

**5.** The color converting material composition according to claim 1 or 4 which converts the absorbed light to light in a wavelength region of 520 to 540 nm and radiates the converted light.

**6.** The color converting material composition according to any one of claims 1 to 5, wherein the organic fluorescent dye is a compound having a perylene skeleton.

**7.** A color converting film comprising the color converting material composition according to any one of claims 1 to 6.

**8.** A color converting substrate comprising:

a substrate; and
the color converting film according to claim 7 formed on the substrate.

**9.** A color converting multi-layer stack comprising:

a first color converting film which contains a first light-transmissible matrix and a fluorescent semiconductor nanocrystal which absorbs light in a first wavelength region; and
a second color converting film which contains a second light-transmissible matrix and an organic fluorescent dye which absorbs light in a second wavelength region.

**10.** A color converting substrate comprising:

a substrate; and
the color converting multi-layer stack according to claim 9 formed on the substrate.

**11.** An emitting device comprising:

a light source having a primary emission wavelength region of 350 to 590 nm; and
the color converting film according to claim 7, the color converting substrate according to claim 8 or 10, or the color converting multi-layer stack according to claim 9.

**12.** The emitting device according to claim 11, wherein the light source is an organic electroluminescent element.

FIG. 1

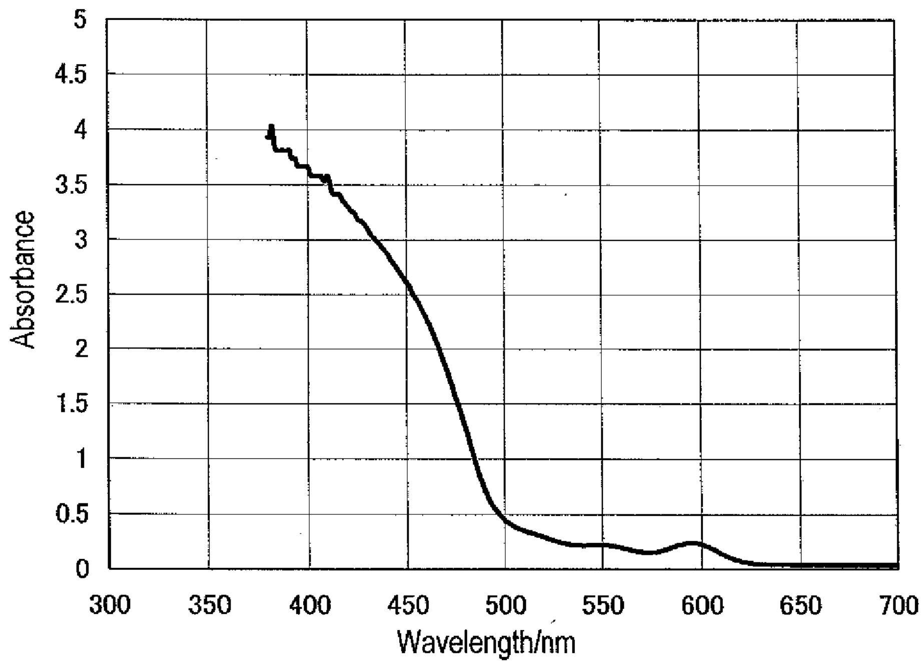
5
4.5
4
3.5
3
2.5
2
1.5
1
0.5
0
Absorbance
300
350
400
450
500
550
600
650
700
Wavelength/nm

FIG. 2

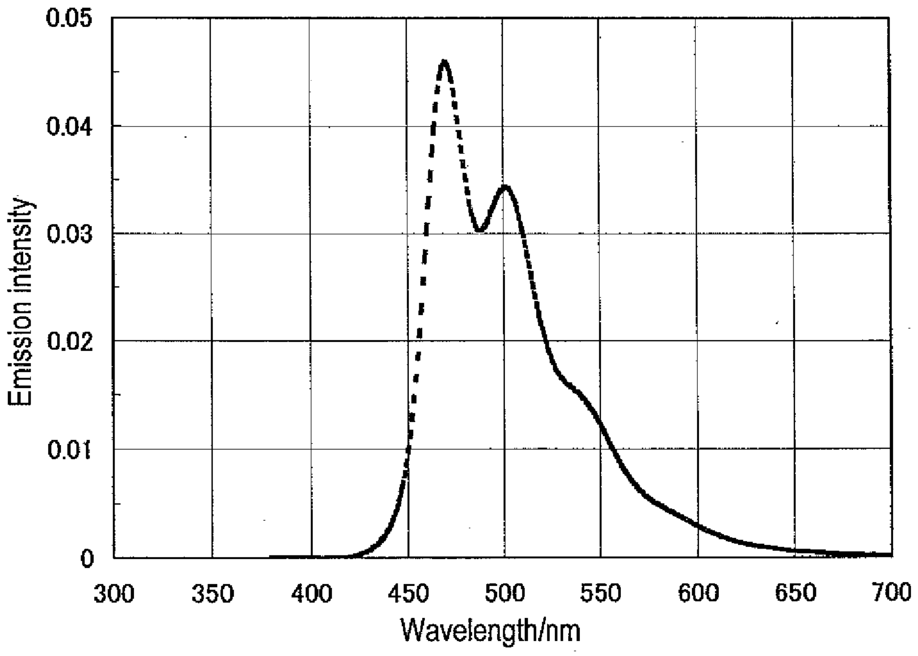
0.05
0.04
0.03
0.02
0.01
0
Emission intensity
300
350
400
450
500
550
600
650
700
Wavelength/nm

FIG. 3

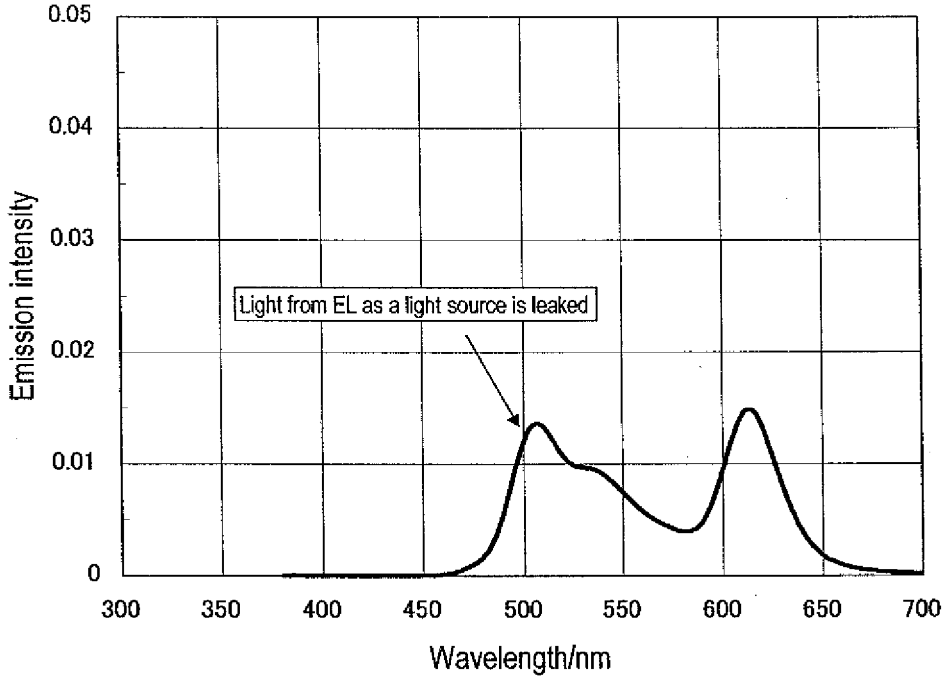
0.05
0.04
0.03
0.02
0.01
0
Emission intensity
Light from EL as a light source is leaked
300
350
400
450
500
550
600
650
700
Wavelength/nm

FIG. 4

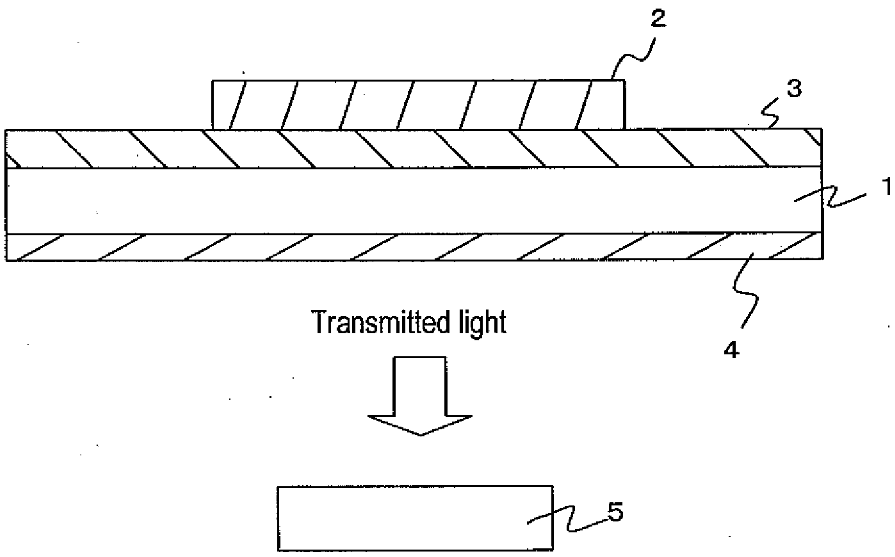
2
3
1
4
Transmitted light
5

**INTERNATIONAL SEARCH REPORT**

International application No.
PCT/JP2006/308665

A. CLASSIFICATION OF SUBJECT MATTER
*H05B33/12*(2006.01), *H01L51/50*(2006.01), *H05B33/14*(2006.01)

According to International Patent Classification (IPC) or to both national classification and IPC

B. FIELDS SEARCHED

Minimum documentation searched (classification system followed by classification symbols)
*H05B33/12*(2006.01), *H01L51/50*(2006.01), *H05B33/14*(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-56813 A (Toshiba Lighting & Technology Corp.), 03 March, 2005 (03.03.05), Claims; Par. Nos. [0040] to [0042] (Family: none) | 1-12 |
| Y | WO 00/17903 A (FED Corp.), 30 March, 2000 (30.03.00), Claims & US 6608439 A & EP 1042775 A | 1-12 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>30 May, 2006 (30.05.06) | Date of mailing of the international search report<br>06 June, 2006 (06.06.06) |
| Name and mailing address of the ISA/<br>Japanese Patent Office<br>Facsimile No. | Authorized officer<br><br>Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6608439 B
- US 6501091 B
- JP 2003286292 A
- JP 2004510678 T
- JP 2004315661 A
- JP 2003505330 T
- JP 11502545 T